# EUROPEAN PATENT SPECIFICATION

(11) **EP 4 567 435 B1**
(45) Date of publication and mention of the grant of the patent: **28.10.2026**
(21) Application number: 23307147.1
(22) Date of filing: 06.12.2023
(51) Int. Cl.: G01R 21/06, G01R 21/07

(54) **POWER DETECTOR AND METHOD FOR OPERATING A POWER DETECTOR**
LEISTUNGSDETEKTOR UND VERFAHREN ZUM BETRIEB EINES LEISTUNGSDETEKTORS
DÉTECTEUR DE PUISSANCE ET PROCÉDÉ DE FONCTIONNEMENT D'UN DÉTECTEUR DE PUISSANCE

(43) Date of publication of application: 11.06.2025
(73) Proprietor: NXP B.V., 5656 AG Eindhoven (NL)
(72) Inventor: Robert, Sebastien, 31023 Toulouse Cedex 1 (FR); Dal Toso, Stefano, 31023 Toulouse Cedex 1 (FR)
(74) Representative: Krott, Michel

(56) References cited:
- US-A- 3 764 908
- US-A- 4 788 494
- US-A1- 2022 091 167

## Description

### TECHNICAL FIELD

The present disclosure relates to a power detector. Furthermore, the present invention relates to a method for operating a power detector.

### BACKGROUND

In conventional electric power detector implementations, a linear multiplication of RF signals is done (current and voltage). The multiplier that does this multiplication needs to be kept linear whatever the PVT conditions in order to have a precise power measurement. Keeping the multiplier linear in PVT requires a big and complex biasing circuit. Moreover the biasing circuit output must be variable with the conditions PVT in order to keep the multiplier in its linear region. Also a variable attenuator is needed to cover the power range to be measured in order to keep the multiplier in its linear region. If all these conditions are not met, then the power measurement suffers from lack of precision and is not usable. Classical power detector implementations suffer from limited precision in PVT and when the voltage standing wave ratio (VSWR) is varied.

V. Qunaj and P. Reynaert, "An E-band Fully-Integrated True Power Detector in 28nm CMOS", University of Leuven, 2019 IEEE Radio Frequency Integrated Circuits Symposium (RFIC), discloses a design of a power amplifier with a low-power fully-integrated E-band true power detector in a 28nm CMOS technology.

US 10,082,528 B2 discloses a power detector including a voltage sensor configured to detect a voltage of a load and a current sensor configured to detect a current of the load. The power detector also includes circuitry configured to introduce a phase delay between the detected voltage of the load and the detected current of the load, thereby producing a voltage measurement and a current measurement. The circuitry is also configured to multiply the voltage measurement and the current measurement.

US 9,686,024 B2 discloses a true radio frequency (RF) power detector, that detects a true power provided by power amplifier of an RF transmitter. The power detector may include a plurality of voltage detectors that determine one or more voltages of a power amplifier included in the RF transmitter and/or a transformer included in the RF transmitter. At least one of the voltage detectors may be coupled to a sense inductor that senses one or more magnetic fields emitted by the transformer. US 3,764,908 A discloses an electronic wattmeter comprising a transformer for measuring the current, a logarithmic multiplier utilized in a single quadrant mode, a relative polarity comparator coupled to a polarity restorer, in which the output of 12 is multiplied by the sign of the product of the polarity comparator.

### SUMMARY

It is an object of the present invention to provide an improved electric power detector.

According to a first aspect, the present disclosure proposes a power detector, comprising:
- a transformer configured to sense an electrical current of a load and to provide an image current of said electric current;
- a first multiplier configured to perform a multiplication of the image current with a sign of a voltage of the load and to feed a result of said multiplication to a filter, the filter configured to provide a DC signal;
- a peak voltage detector configured to determine a peak value of the voltage;
- a second multiplier configured to perform a linear multiplication of the output of the filter with the peak value; and
- a biasing circuit configured to provide a biasing signal for the first multiplier, wherein the biasing signal is essentially independent of temperature and/or process of the first multiplier.

In this way, a biasing circuit can be implemented more easier than in prior art. This is due to the fact that the first multiplier is implemented as a non-linear hard switching mixer, which means that no compensation for non-linearity of the multiplier is necessary. The second multiplier multiplies two DC signals, hence the second multiplier may be implemented easier than in prior art. As a result, a current and semiconductor area-saving design of the proposed power detector is implementable. The proposed power detector offers an improved trade-off between precision and area.

According to a further aspect, the present disclosure proposes a method for operating a power detector, comprising the steps:
- sensing an electrical current of a load and providing an image current of said electric current;
- performing a multiplication of the image current with a sign of a voltage of the load;
- feeding the result of said multiplication to a filter, the filter configured to provide a DC signal;
- determining a peak value of the voltage;
- performing a linear multiplication of the output of the filter with the peak value; and
- providing a biasing signal for the first multiplier during the measurement of the electric power of the load, wherein the biasing signal is essentially independent of temperature and/or process of the first multiplier.

In one or more embodiments, an output signal of the filter represents a multiplication of the image current by the cosine of a phase difference between the load current and the load voltage.

In one or more embodiments, the biasing circuit is one of the following: constant current source, voltage source of a bandgap.

In one or more embodiments, the power detector further comprises an attenuator configured to adapt a working range of the first multiplier. In this way, the existence of the attenuator depends on a range which is intended to be measured. If the power is too great and to prevent damage of components of the first multiplier, the attenuator may be required.

According to one or more embodiments, the attenuator is programmable.

According to one or more embodiments, the second multiplier is a digital multiplier. The linear multiplication of the output of the peak voltage detector and the filter is done in the digital world due to static input signals to the second multiplier.

According to one or more embodiments the second multiplier is an analog multiplier.

According to one or more embodiments the biasing circuit and the attenuator are implemented in one single element.

According to one or more embodiments the first multiplier corresponds to a Heaviside function of the voltage instead of the sign function.

Various example embodiments may be more completely understood in consideration of the following detailed description in connection with the accompanying drawings, in which:
- FIG. 1: shows a block diagram of the conventional power detector;
- FIG. 2: shows a block diagram of a further conventional power detector;
- FIG. 3: shows a block diagram of an embodiment of a proposed power detector;
- FIG. 4: shows a block diagram of a further embodiment of the proposed power detector;
- FIG. 5: shows a block diagram of a further embodiment of the proposed power detector; and
- FIG. 6: is a diagram showing a flow of a proposed method of operating a power detector.

### BRIEF DESCRIPTION OF DRAWINGS

The above discussion/summary is not intended to describe each embodiment or every implementation of the present disclosure. The drawings and detailed description that follow also exemplify various embodiments. The aspects defined above and further aspects of the present disclosure are apparent from the examples of embodiment to be described hereinafter with reference to the appended drawings, which are explained with reference to the examples of embodiment. Needless to say, that the disclosure is not limited to the examples of embodiments.

All illustrations in the drawings are schematical. It is noted that in different figures, similar or identical elements or features are provided with the same reference signs or with reference signs that are different from the corresponding reference signs only within the first digit. In order to avoid unnecessary repetitions, elements or features which have already been elucidated with respect to a previously described embodiment are not elucidated again at a later position of the description.

### DESCRIPTION OF EMBODIMENTS

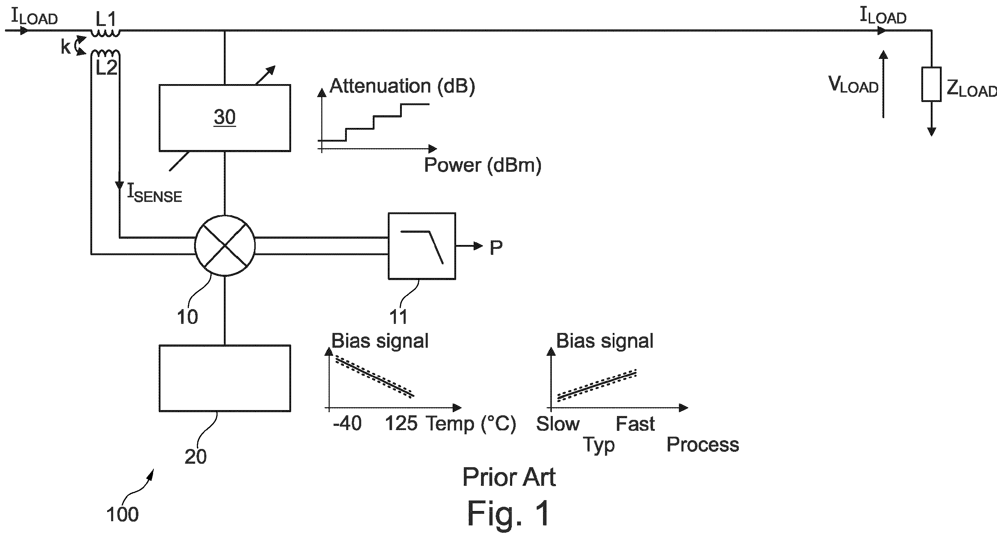

FIG. 1 shows a block diagram of a conventional electric power detector 100 for measuring electric power of a load Z_{LOAD}. Basically, said power is measured by a multiplication of an image current I_{SENSE} of an electric current I_{LOAD} and an electric voltage V_{LOAD} of the load Z_{LOAD}. The voltage V_{LOAD} is sensed by an attenuator 30 and is fed to a first multiplier 10. One recognizes a transformer having two inductors L1, L2 with a transfer factor k, which senses an image current I_{SENSE}, which is fed to the first multiplier 10. The first multiplier 10 performs a multiplication of the image current I_{SENSE} with the voltage V_{LOAD} and may be somewhat sensitive to variations of temperature and process variations. That is, the first multiplier 10 performs a linear multiplication of RF signals.

To this end, the first multiplier 10 needs to be biased by means of biasing signals of a biasing circuit 20 in order to keep operating characteristics of the first multiplier 10 as linear as possible. In addition, an attenuator 30 is provided, which adjusts a suitable working range for the first multiplier 10. An output of the first multiplier 10 is filtered by a filter 11 in order to provide a DC signal. Said DC signal is an image of the electric power P of the load Z_{LOAD}.

As the value of the output of the first multiplier 10 is important, it is important that the first multiplier 10 has linear characteristics. The attenuator 30 is needed because a certain range of the power P in the load Z_{LOAD} is measured, in order to hold the input of the first multiplier 10 quite constant within a given power range. This is indicated with a sub diagram near the attenuator 30 showing exemplary attenuation steps of a programmable step attenuator over power.

The biasing circuit 20 needs to follow a behavior of the first multiplier 10 in terms of temperature and process, in order to keep the first multiplier 10 in its linear region, which is indicated in two exemplary sub diagrams next to the biasing circuit 20. The biasing circuit 20 can be e.g. a current source or a voltage regulator. The linear first multiplier 10 is done in analog way with transistors and a transfer function of the first multiplier 10 is not linear over temperature and process, therefore its output does not exactly represent a multiplication of both inputs, when the temperature and/or the process changes. Said biasing circuit 20 needs to be precise in order to keep the linear first multiplier 10 in its linear region, which requires great semiconductor area. Moreover, the biasing circuit 20 needs a variable output signal versus PVT, which may results in a rather complex implementation of the biasing circuit 20.

A measurement of the RMS power P_{LOAD} in the load Z_{LOAD} at the frequency ω/2p can be done in the following way: ${V}_{LOAD} \left(t\right) = {V}_{L} sin \left(ωt\right)$ ${I}_{LOAD} \left(t\right) = {I}_{L} sin \left(ωt+φ\right)$ ${P}_{LOAD} = \frac{{V}_{L} {I}_{L}}{2} cos \left(φ\right)$ with the parameters:
- V_{L}: peak value of load voltage
- I_{L}: peak value of load current
- φ: phase between load voltage and load current

The RMS power P_{LOAD} can be evaluated by linearly multiplying I_{LOAD} and V_{LOAD} and taking the DC term of the multiplied signal: $m \left(t\right) = {V}_{LOAD} \left(t\right) ⋅ {I}_{LOAD} \left(t\right)$ $m \left(t\right) = \frac{{V}_{L} {I}_{L}}{2} \left(cos\left(φ\right)-cos\left(2ωt+φ\right)\right)$ ${m}_{DC} = \frac{{V}_{L} {I}_{L}}{2} cos \left(φ\right) = {P}_{LOAD}$

This method requires an analog RF multiplier 10 that perform the linear time multiplication between the two RF signals. Such multiplier is difficult to implements over a wide range of P_{LOAD} and over process, voltage, and temperature variation (PVT).

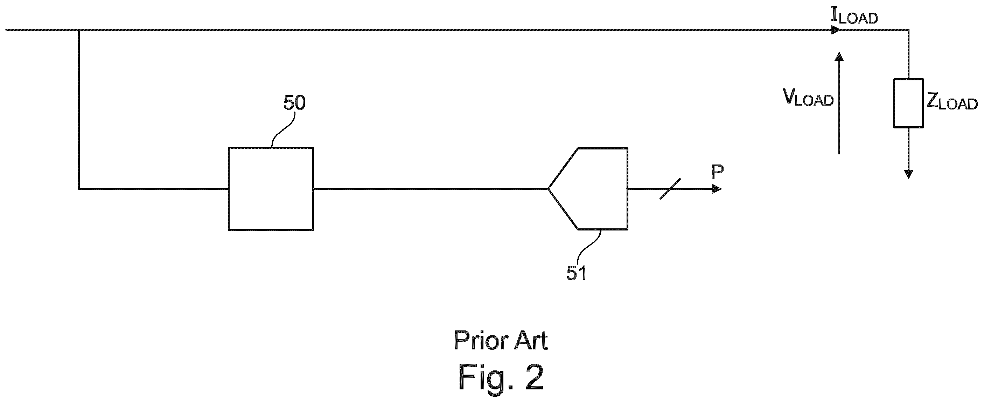

FIG. 2 shows a detail of a conventional implementation of a power detector that uses a voltage peak detector 50. In effect, this represents an example of a power detector that is done only with a peak detector 50. The RMS power can also be measured with a peak voltage detector 50 only in case the impedance of the load Z_{LOAD} is well known, for example 50 Ohms fixed. An output signal of the peak voltage detector 50 is proportional to V_{LOAD} and is fed to an ADC 51, which outputs a signal being representative of the power P.

In case the load impedance Z_{LOAD} is purely resistive (e.g. 50 Ohms), the RMS power is obtained from the V_{LOAD} information from the peak voltage detector 50 as follows: ${P}_{LOAD} = \frac{{{V}_{L}}^{2}}{100}$

The voltage V_{LOAD} and the current I_{LOAD} are in phase in this case, which results in a kind of pure voltage detector. However, a problem in this case may be, that if the load impedance varies, then the power measured through the peak voltage detector 50 only is no more accurate.

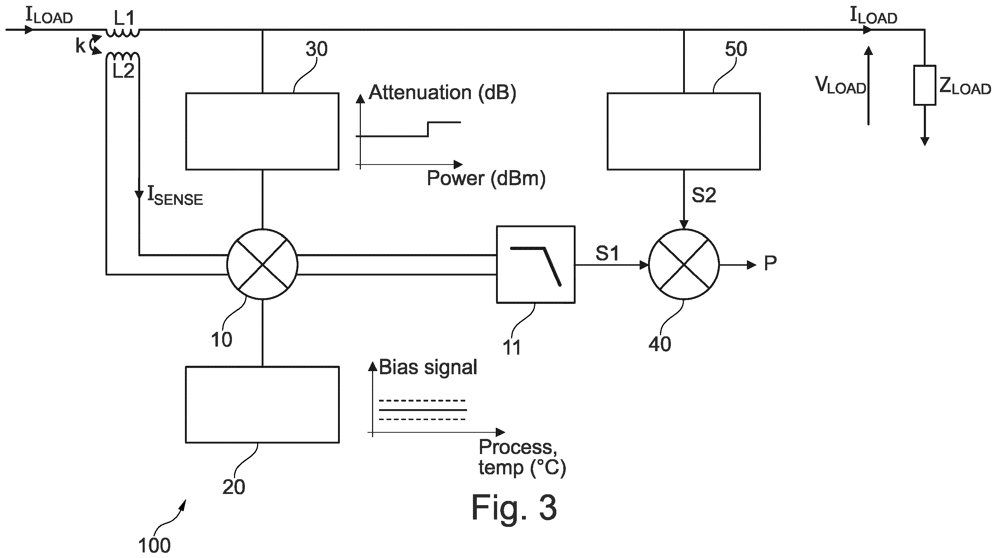

FIG. 3 is a block diagram of a first embodiment of the proposed power detector 100. One recognizes the transformer having two inductors L1, L2 with a transmission factor k provides an image I_{SENSE} of the current I_{LOAD} and the biasing circuit 20. Differing from the conventional arrangement shown in FIG. 1, a first multiplier 10 uses the image current I_{SENSE} and furthermore uses a phase relationship with a phase φ between the current I_{LOAD} and the voltage V_{LOAD}. The cosine φ is a phase relation between current I_{LOAD} and voltage V_{LOAD} of the load Z_{LOAD}. The first multiplier performs a multiplication of the image current I_{SENSE} and a sign of the relationship and provides said image to a filter 11, which provides a DC signal S1 and feeds said DC signal S1 to a second multiplier 40. The first multiplier 10 is implemented as a non-linear hard switching mixer, which means that the mixer does not do a multiplication of the two inputs, rather one of its inputs has a very high amplitude in order to do a switching operation and it is essentially non-linear.

In effect, the first multiplier 10 has a non-linear transfer function, which means, that the first multiplier 10 is used as a limiter. As a result, the first multiplier 10 is used as a hard switching mixer. Only a characteristic of edges (rising or falling edge) of the input signal (V_{OUT}) is determined, such that the phase relationship of input signals is known. At the output of the first multiplier 10 a signal is provided, wherein such signal represents the multiplication of the image of the current I_{SENSE} with the phase of the output voltage V_{OUT}.

The attenuator 30 may be optional, depending on a range which is intended to be detected, in order to protect components of the first multiplier 10 from damage. In case, that the output of the first multiplier 10 is not too strong, the attenuator 30 is not required. The output S1 of the filter 11 removes the high frequency component of the first multiplier output signal, leaving only the DC component. Its output signal S1 represents the multiplication of the image of the current I_{SENSE} by the cosine of the phase difference between the load current (I_{LOAD}) and the load voltage (V_{OUT}).

In addition to the load current and the phase information between load current and load voltage, also an information regards the load voltage amplitude is needed. To this end, a peak voltage detector 50 is used, which is much easier to be implemented than a power detector. An output signal S2 of a maximum peak detector 50 represents a peak value of the voltage V_{LOAD}. Both signals S1, S2 are DC signals so they can be multiplied by the linear multiplier 40 via a linear multiplication in analog or in digital.

One recognizes a biasing circuit 20 being functionally connected with the first multiplier 10 and a biasing signal diagram, with a biasing signal being essentially independent of process and temperature. This allows a much more easier implementation of the biasing circuit 20. For example, the biasing circuit 20 can be implemented as a constant current source, voltage source from a bandgap, etc.

An optional attenuator 30 is provided in a case, that an operation range has to be adjusted for the first multiplier 10. Alternatively, the biasing circuit 20 and the attenuation circuit 50 can be implemented in one single element. Also, the attenuator 30 can be implemented as a programmable unit.

As a result, in the proposed power detector 100 the linear multiplier of the two RF signal as performed in the arrangement of FIG. 1 is replaced by two multipliers 10, 40 and a voltage peak detector 50. That means a hard switching RF multiplier is provided to retrieve a phase relationship between the RF current and the voltage of the load together with a linear second multiplier 40, whose input signals S1, S2 are DC-signals. Resulting therefrom, a much relaxed biasing circuit 20 for the RF multiplier 10 is implementable, since doesn't have to operate in linear region anymore. For the same power range to be covered the attenuator 30 may be simpler and might even be removed. The linear multiplication of the second multiplier 40 is performed between DC signals, which is much easier to implement and can be done in digital (after ADC conversion) or in analog.

The same results can be achieved by multiplying I_{LOAD} by the sign of V_{LOAD}, taking the DC value of the multiplication, and multiplying such DC value by the peak value of V_{LOAD} in the following way: $m \left(t\right) = sign \left({V}_{LOAD}\left(t\right)\right) ⋅ {I}_{LOAD} \left(t\right)$ $sign \left({V}_{LOAD}\left(t\right)\right) = \frac{4}{π} \left(sin\left(ωt\right)+\frac{sin \left(3ωt\right)}{3}+\frac{sin \left(5ωt\right)}{5}+⋯\right)$ $m \left(t\right) = \frac{4}{π} \frac{{I}_{L}}{2} \left(\begin{matrix}cos \left(φ\right) - cos \left(2ωt+φ\right) + \frac{cos \left(-2ωt+φ\right) - cos \left(4ωt+φ\right)}{3} \\ + \frac{cos \left(-4ωt+φ\right) - cos \left(6ωt+φ\right)}{5} + ⋯\end{matrix}\right)$ ${m}_{DC} = \frac{4}{π} \frac{{I}_{L}}{2} cos \left(φ\right)$ ${m}_{DC} ⋅ {V}_{peak} \left({V}_{LOAD}\left(t\right)\right) = \frac{4}{π} \frac{{V}_{L} {I}_{L}}{2} cos \left(φ\right) = \frac{4}{π} {P}_{LOAD}$ with m_{DC} as the DC part of the output of the filter 11 (signal S1) and where the factor 4/ π can easily be de-embedded. Vₚₑₐₖ represents a peak value of the voltage as determined by the peak voltage detector 50. $\frac{4}{π}$ scaling factor, which takes into account a relationship between sine wave and square wave

In the proposed power detector 100 the hard switching mixer of the first multiplier10 may correspond to a Heaviside function of V_{LOAD}, instead of the sign function, thus a factor of two must be applied.

An advantage of the proposed power detector 100 and its performed method of power detection is that the required linear multiplication is now applied to two DC signals, and is then much easier to implement (either in analog or digital). The first multiplication still require to multiply two RF signals, but it can be implemented as a hard-switching multiplier, that is much easier to implement over a wide range of P_{LOAD} and PVT.

Resulting therefrom, the proposed power detector 100 is easier to be implemented than in a conventional way and allows a current saving and/or area saving implementation of the power detector.

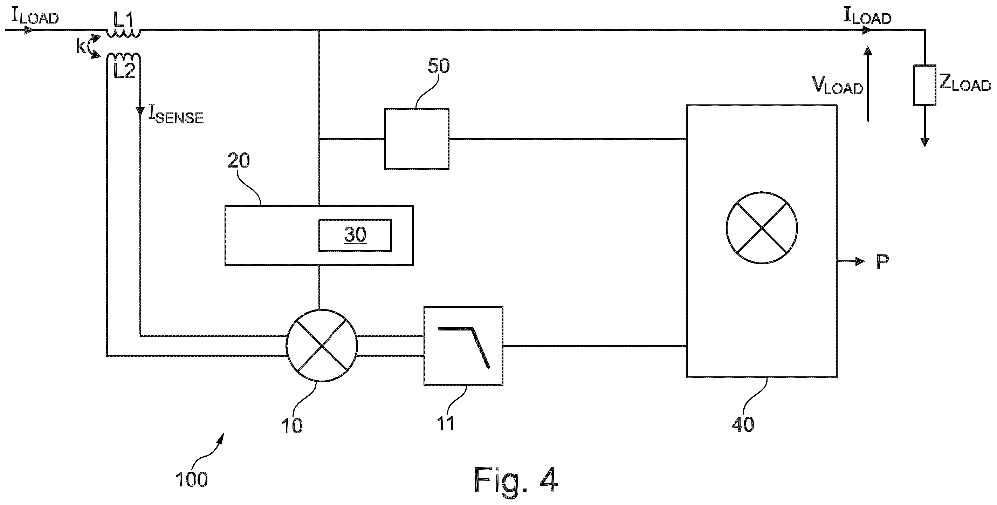

FIG. 4 shows a block diagram of a further embodiment of the proposed power detector 100. The coupled inductors L₁, L₂ provide an image current I_{SENSE} of the load current I_{LOAD}. The way the current is sensed is not restrictive, and it could be done also with a sense inductor coupled to a transformer.

The "hard switching" first multiplier 10 implements the multiplication between the image current I_{SENSE} of the current I_{LOAD} and the sign(V_{LOAD}(t)). The filter 11 at the output of the first multiplier 10 isolates the DC component of the signal and provides some amplification. An DC signal at the output of the filter 11 is proportional I_{LOAD} * cos φ. An output signal of the peak voltage detector 50 is proportional to V_{LOAD}.

Also in this case, the linear second multiplier 40 can be implemented either in the analog or in the digital domain. One recognizes, that the biasing circuit 20 and the attenuator 30 may be combined in one single element.

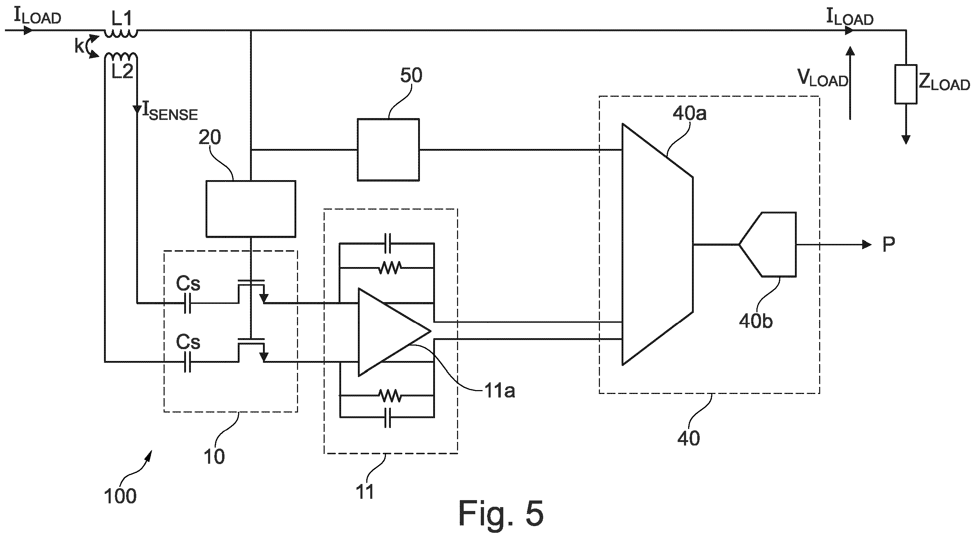

FIG. 5 shows a block diagram of a further exemplary embodiment of the proposed power detector 100. In this implementation the first multiplier 10 (hard switching mixer) comprises capacitors Cs and FETs having been implemented with a passive switching mixer design. The output current of the first multiplier 10 is filtered by means of the filter 11 with a trans-impedance amplifier (TIA) 11a and converted into a voltage signal. The linear multiplication by means of the second multiplier 40 is performed in the digital domain by means of a multiplexer 40a and an analog-to-digital converter 40b. Since both signals to be multiplied by the second multiplier 40 are DC signals, a single time multiplexed ADC is sufficient.

Most of today IC already contains a general-purpose ADC anyway. In this case the digital linear multiplication does not require any additional hardware other than the actual multiplier (few digital gates).

The following table shows numerical values of different power detectors as explained in the foregoing:

**Table 1**

| Conventional power detector with RF passive mixer in linear region | Proposed power detector with passive mixer switching mode and peak detector | Conventional peak voltage detector only |
|---|---|---|
| 5 dBm - 15 dBm | 5 dBm - 15 dBm | -2 dBm - 17 dBm |
| 3 | 0 | 1 |
| +/- 1 dB | +/- 1 dB | +/- 4 dB |
| 17.000 µm² | 4.500 µm² | 1.000 µm² |
| 100 µA | 10 µA | - |

Line 2 ... Antenna power range
Line 3 ... Number of attenuator steps
Line 4 ... overall precision
Line 5 ... estimated silicon area
Line 6 ... current consumption of the biasing circuit 20

As can be seen from table 1, the proposed power detector 100 with numerical values shown in column 2 has a good tradeoff between the power detection precision and silicon area. It also leads to less electric current consumption as the biasing circuit for the mixer is simpler, it can be made for example of a basic resistive divider between V_{dd} and the ground.

The +/- 4 dB precision for the peak voltage detector shown in FIG. 2 is due to the VSWR variation between 1 and 2. The proposed power detector has a good precision of +/-1 dB even with a VSWR variation between 1 and 2.

The proposed power detector 100 provides a way to implement a true power detector by removing linear multiplication of the RF-signals (current and voltage). The proposed power detector features a circuit that generates a replica I_{SENSE} of the load output current I_{LOAD}, a voltage detector, that generate a DC signal proportional to the load voltage V_{LOAD}, and two multipliers: a first multiplier 10 that performs the multiplication between I_{SENSE} and the sign of V_{LOAD}, and a second multiplier 40 that performs the multiplication between the DC components of the first multiplier output, and the voltage detector output.

A filter 11 might be needed in between the first multiplier output and the second multiplier input to extract only the DC-value of the signal and provides some amplification.

One recognizes that only the second multiplier 40 performs a linear multiplication. Due to the fact that it multiplies two DC signals, it is much easier to implements compared to prior art, where the linear multiplier 10 multiplies two RF signals.

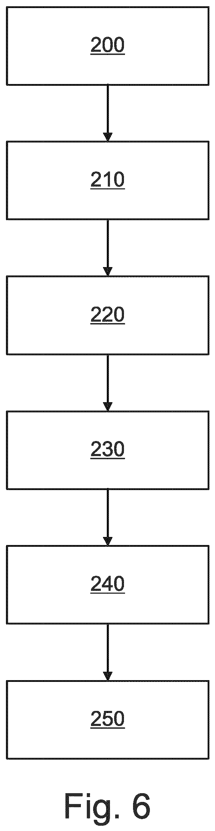

FIG. 6 shows a principal flow of the proposed method:
In a step 200, a an electrical current I_{LOAD} of a load Z_{LOAD} is sensed and an image current I_{SENSE} of said electric current I_{LOAD} is provided.
In a step 210 a multiplication of the image current I_{SENSE} with a sign of a voltage V_{LOAD} of the load Z_{LOAD} is performed.
In a step 220 the result of said multiplication is fed to a filter 11, the filter 11 configured to provide a DC signal.
In a step 230 a peak value S2 of the voltage V_{LOAD} is determined.
In a step 240 a linear multiplication of the output S1 of the filter 11 with the peak value S2 is performed.
In a step 250 a biasing signal for the first multiplier 10 during the measurement of the electric power of the load Z_{LOAD} is provided, wherein the biasing signal is essentially independent of temperature and/or process of the first multiplier 10.

All mentioned numerical values are only exemplary and can be exchanged with alternative suitable numerical values. Also, the disclosed numerical values are to be understood in a qualitative sense and are represented in a standardized form.

What is new in the proposed invention is to do a power detector by doing two successive multiplications : a first multiplication between I_{SENSE} and the sign of V_{LOAD}, and a second multiplication between the DC components of the first multiplier output, and the peak voltage detector output, instead of a single RF multiplication of voltage and current as in classical power detectors. The specifications for the linear multiplier are relaxed, and a digital implementation is now possible, that allow to do a very precise linear multiplication with only few digital gates, leading to a power detector with a good precision with less silicon area. The biasing for the RF multiplier and the optional RF attenuator are relaxed because the RF multiplier doesn't have to be linear anymore.

The proposed power detector 100 can e.g. be used for a radio platform for Bluetooth connectivity.

In the foregoing description various specific details have been set forth to describe specific examples presented herein. It should be apparent to one skilled in the art, however, that one or more other examples and/or variations of these examples may be practiced without all the specific details given below. In other instances, well known features have not been described in detail so as not to obscure the description of the examples herein. For ease of illustration, the same reference signs may be used in different diagrams to refer to the same elements or additional instances of the same element.

As examples, the specification describes and/or illustrates aspects useful for implementing the claimed disclosure by way of various circuits or circuitry which may be illustrated as or using terms such as blocks, modules, device, system, unit, controller, etc. and/or other circuit-type depictions. Such circuits or circuitry are used together with other elements to exemplify how certain embodiments may be carried out in the form or structures, steps, functions, operations, activities, etc. As examples, wherein such circuits or circuitry may correspond to logic circuitry (which may refer to or include a code-programmed/configured CPU, in one example the logic circuitry may carry out a process or method (sometimes "algorithm") by performing such activities and/or steps associated with the above-discussed functionalities. In other examples, the logic circuitry may carry out a process or method by performing these same activities/operations.

For example, in certain of the above-discussed embodiments, one or more modules are discrete logic circuits or programmable logic circuits configured and arranged for implementing these operations/activities. In certain embodiments, such a programmable circuit is one or more computer circuits, including memory circuitry for storing and accessing a program to be executed as a set (or sets) of instructions (and/or to be used as configuration data to define how the programmable circuit is to perform), and an algorithm or process as described above is used by the programmable circuit to perform the related steps, functions, operations, activities, etc. Depending on the application, the instructions (and/or configuration data) can be configured for implementation in logic circuitry, with the instructions (whether characterized in the form of object code, firmware or software) stored in and accessible from a memory (circuit). As another example, where the specification may make reference to a "first" type of structure, a "second" type of structure, where the adjectives "first" and "second" are not used to connote any description of the structure or to provide any substantive meaning; rather, such adjectives are merely used for English-language antecedence to differentiate one such similarly-named structure from another similarly-named structure.

Based upon the above discussion and illustrations, those skilled in the art will readily recognize, that various modifications and changes may be made to the various embodiments without strictly following the exemplary embodiments and applications illustrated and described herein. For example, methods as exemplified in the Figures may involve steps carried out in various orders, with one or more aspects of the embodiments herein retained, or may involve fewer or more steps.

While various embodiments discussed herein are amenable to modifications and alternative forms, aspects thereof have been shown by way of example in the drawings and will be described in detail. It should be understood, however, that the intention is not to limit the disclosure to the particular embodiments described. On the contrary, the intention is to cover all modifications, equivalents, and alternatives falling within the scope of the disclosure including aspects defined in the claims. In addition, the term "example" as used throughout this application is only by way of illustration, and not limitation.

It should be noted that the term "comprising" does not exclude other elements or steps and "a" or "an" does not exclude a plurality. Also elements described in association with different embodiments may be combined. It should also be noted, that reference signs in the claims should not be construed as limiting the scope of the claims.

The discloses devices, apparatuses, units, elements, systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer readable medium, which may include storage devices and signals, in compressed or uncompressed form.

It is noted that the embodiments above have been described with reference to different subject-matters. In particular, some embodiments may have been described with reference to method-type claims whereas other embodiments may have been described with reference to apparatus-type claims.

### Reference signs:

- 10: first multiplier
- 11: filter
- 20: biasing circuit
- 30: attenuator
- 40: second multiplier
- 40a: multiplexer
- 40b: ADC
- 50: voltage peak detector
- 51: ADC
- 100: power detector
- 200...250: method steps
- L1, L2: inductor
- I_{LOAD}: load current
- I_{SENSE}: image current
- V_{LOAD}: load voltage
- Z: load

## Claims

1. Power detector (100), comprising:
- a transformer (L1, L2) configured to sense an electrical current (I_{LOAD}) of a load (Z_{LOAD}) and to provide an image current (I_{SENSE}) of said electric current (ILOAD);
- a first multiplier (10) configured to perform a multiplication of the image current (I_{SENSE}) with a sign of a voltage (V_{LOAD}) of the load (Z_{LOAD}) and to feed a result of said multiplication to a filter (11), the filter (11) configured to provide a DC signal;
- a peak voltage detector (50) configured to determine a peak value (S2) of the voltage (V_{LOAD});
- a second multiplier (40) configured to perform a linear multiplication of the output (S1) of the filter (11) with the peak value (S2); and
- a biasing circuit (20) configured to provide a biasing signal for the first multiplier (10), wherein the biasing signal is essentially independent of temperature and/or process of the first multiplier (10).

2. Power detector (100) according to claim 1, wherein an output signal (S1) of the filter (11) represents a multiplication of the image current (I_{SENSE}) by the cosine of a phase difference between the load current (I_{LOAD}) and the load voltage (V_{OUT}).

3. Power detector (100) according to claim 1 or 2, wherein the biasing circuit (20) is one of the following: constant current source, voltage source of a bandgap.

4. Power detector (100) according to any of the preceding claims, further comprising an attenuator (30) configured to adapt a working range of the first multiplier (10).

5. Power detector (100) according to claim 4, wherein the attenuator (30) is programmable.

6. Power detector (100) according to any of the preceding claims, wherein the second multiplier (40) is a digital multiplier.

7. Power detector (100) according to any of claims 1 to 5, wherein the second multiplier (40) is an analog multiplier.

8. Power detector (100) according to any of claims 4 to 7, wherein the biasing circuit (20) and the attenuator (30) are implemented in one single element.

9. Power detector (100) according to any of the preceding claims, wherein the first multiplier (10) corresponds to a Heaviside function of the voltage (V_{LOAD}) instead of the sign function.

10. Method for providing a measurement of electric power of a load (Z_{LOAD}), comprising the steps:
- sensing an electrical current (I_{LOAD}) of a load (Z_{LOAD}) and providing an image current (I_{SENSE}) of said electric current (I_{LOAD});
- performing a multiplication of the image current (I_{SENSE}) with a sign of a voltage (V_{LOAD}) of the load (Z_{LOAD})
- feeding the result of said multiplication to a filter (11), the filter (11) configured to provide a DC signal;
- determining a peak value (S2) of the voltage (V_{LOAD});
- performing a linear multiplication of the output (S1) of the filter (11) with the peak value (S2); and
- providing a biasing signal for the first multiplier (10) during the measurement of the electric power of the load (Z_{LOAD}), wherein the biasing signal is essentially independent of temperature and/or process of the first multiplier (10).

11. Method according to claim 10, wherein the linear multiplication of the output (S1) of the filter (11) with the peak value (S2) is done in digital.

12. Method according to claim 10, wherein the linear multiplication of the output (S1) of the filter (11) with the peak value (S2) is done in analog.

13. Method according to any of the claims 10 to 12, further comprising an adaptation of a working range of the first multiplier (10).

## Patentansprüche

1. Leistungsdetektor (100), umfassend:
- einen Transformator (L1, L2), der dazu ausgelegt ist, einen elektrischen Strom (I_{LAST}) einer Last (Z_{LAST}) zu erfassen und einen Abbildstrom (I_{ERFASSUNG}) des elektrischen Stroms (I_{LAST}) bereitzustellen;
- einen ersten Multiplizierer (10), der dazu ausgelegt ist, eine Multiplikation des Abbildstroms (I_{ERFASSUNG}) mit einem Vorzeichen einer Spannung (V_{LAST}) der Last (Z_{LAST}) durchzuführen und ein Ergebnis der Multiplikation einem Filter (11) zuzuführen, wobei das Filter (11) dazu ausgelegt ist, ein Gleichstromsignal bereitzustellen;
- einen Spitzenspannungsdetektor (50), der dazu ausgelegt ist, einen Spitzenwert (S2) der Spannung (V_{LAST}) zu bestimmen;
- einen zweiten Multiplizierer (40), der dazu ausgelegt ist, eine lineare Multiplikation der Ausgabe (S1) des Filters (11) mit dem Spitzenwert (S2) durchzuführen; und
- eine Vorspannungsschaltung (20), die dazu ausgelegt ist, ein Vorspannungssignal für den ersten Multiplizierer (10) bereitzustellen, wobei das Vorspannungssignal im Wesentlichen unabhängig von Temperatur und/oder Prozess des ersten Multiplizierers (10) ist.

2. Leistungsdetektor (100) nach Anspruch 1, wobei ein Ausgangssignal (S1) des Filters (11) eine Multiplikation des Abbildstroms (I_{ERFASSUNG}) mit dem Cosinus einer Phasendifferenz zwischen dem Laststrom (I_{LAST}) und der Lastspannung (V_{OUT}) repräsentiert.

3. Leistungsdetektor (100) nach Anspruch 1 oder 2, wobei die Vorspannungsschaltung (20) eines der Folgenden ist: Konstantstromquelle, Spannungsquelle einer Bandlücke.

4. Leistungsdetektor (100) nach einem der vorhergehenden Ansprüche, der ferner ein Dämpfungsglied (30) umfasst, das dazu ausgelegt ist, einen Arbeitsbereich des ersten Multiplizierers (10) anzupassen.

5. Leistungsdetektor (100) nach Anspruch 4, wobei das Dämpfungsglied (30) programmierbar ist.

6. Leistungsdetektor (100) nach einem der vorhergehenden Ansprüche, wobei der zweite Multiplizierer (40) ein digitaler Multiplizierer ist.

7. Leistungsdetektor (100) nach einem der Ansprüche 1 bis 5, wobei der zweite Multiplizierer (40) ein analoger Multiplizierer ist.

8. Leistungsdetektor (100) nach einem der Ansprüche 4 bis 7, wobei die Vorspannungsschaltung (20) und das Dämpfungsglied (30) in einem einzigen Element implementiert sind.

9. Leistungsdetektor (100) nach einem der vorhergehenden Ansprüche, wobei der erste Multiplizierer (10) einer Heaviside-Funktion der Spannung (V_{LAST}) anstelle der Vorzeichenfunktion entspricht.

10. Verfahren zum Bereitstellen einer Messung der elektrischen Leistung einer Last (Z_{LAST}), das die folgenden Schritte umfasst:
- Erfassen eines elektrischen Stroms (I_{LAST}) einer Last (Z_{LAST}) und Bereitstellen eines Abbildstroms (I_{ERFASSUNG}) des elektrischen Stroms (I_{LAST});
- Durchführen einer Multiplikation des Abbildstroms (I_{ERFASSUNG}) mit einem Vorzeichen einer Spannung (V_{LAST}) der Last (Z_{LAST})
- Zuführen des Ergebnisses der Multiplikation zu einem Filter (11), wobei das Filter (11) dazu ausgelegt ist, ein Gleichstromsignal bereitzustellen;
- Bestimmen eines Spitzenwerts (S2) der Spannung (V_{LAST});
- Durchführen einer linearen Multiplikation der Ausgabe (S1) des Filters (11) mit dem Spitzenwert (S2); und
- Bereitstellen eines Vorspannungssignals für den ersten Multiplizierer (10) während der Messung der elektrischen Leistung der Last (Z_{LAST}), wobei das Vorspannungssignal im Wesentlichen unabhängig von Temperatur und/oder Prozess des ersten Multiplizierers (10) ist.

11. Verfahren nach Anspruch 10, wobei die lineare Multiplikation der Ausgabe (S1) des Filters (11) mit dem Spitzenwert (S2) digital erfolgt.

12. Verfahren nach Anspruch 10, wobei die lineare Multiplikation der Ausgabe (S1) des Filters (11) mit dem Spitzenwert (S2) analog erfolgt.

13. Verfahren nach einem der Ansprüche 10 bis 12, das ferner eine Anpassung eines Arbeitsbereichs des ersten Multiplizierers (10) umfasst.

## Revendications

1. Détecteur de puissance (100), comprenant :
- un transformateur (L1, L2) configuré pour détecter un courant électrique (I_{LOAD}) d'une charge (Z_{LOAD}) et pour fournir un courant image (I_{SENSE}) dudit courant électrique (I_{LOAD}) ;
- un premier multiplieur (10) configuré pour effectuer une multiplication du courant image (I_{SENSE}) par un signe d'une tension (V_{LOAD}) de la charge (Z_{LOAD}) et pour alimenter un résultat de ladite multiplication à un filtre (11), le filtre (11) étant configuré pour fournir un signal CC ;
- un détecteur de tension de crête (50) configuré pour déterminer une valeur de crête (S2) de la tension (V_{LOAD}) ;
- un deuxième multiplicateur (40) configuré pour réaliser une multiplication linéaire de la sortie (S1) du filtre (11) avec la valeur de crête (S2) ; et
- un circuit de polarisation (20) configuré pour fournir un signal de polarisation pour le premier multiplicateur (10), dans lequel le signal de polarisation est essentiellement indépendant de la température et/ou du processus du premier multiplicateur (10).

2. Détecteur de puissance (100) selon la revendication 1, dans lequel un signal de sortie (S1) du filtre (11) représente une multiplication du courant d'image (I_{SENSE}) par le cosinus d'une différence de phase entre le courant de charge (I_{LOAD}) et la tension de charge (V_{OUT}).

3. Détecteur de puissance (100) selon la revendication 1 ou 2, dans lequel le circuit de polarisation (20) est l'un des suivants : source de courant, source de tension constant(e) d'une bande interdite.

4. Détecteur de puissance (100) selon l'une quelconque des revendications précédentes, comprenant en outre un atténuateur (30) configuré pour adapter une plage de travail du premier multiplicateur (10).

5. Détecteur de puissance (100) selon la revendication 4, dans lequel l'atténuateur (30) est programmable.

6. Détecteur de puissance (100) selon l'une quelconque des revendications précédentes, dans lequel le deuxième multiplicateur (40) est un multiplicateur numérique.

7. Détecteur de puissance (100) selon l'une quelconque des revendications 1 à 5, dans lequel le deuxième multiplicateur (40) est un multiplicateur analogique.

8. Détecteur de puissance (100) selon l'une quelconque des revendications 4 à 7, dans lequel le circuit de polarisation (20) et l'atténuateur (30) sont mis en œuvre en un seul élément.

9. Détecteur de puissance (100) selon l'une quelconque des revendications précédentes, dans lequel le premier multiplicateur (10) correspond à une fonction Heaviside de la tension (V_{LOAD}) au lieu de la fonction signe.

10. Procédé de fourniture d'une mesure de puissance électrique d'une charge (Z_{LOAD}), comprenant les étapes de :
- détection d'un courant électrique (I_{LOAD}) d'une charge (Z_{LOAD}) et fourniture d'un courant image (I_{SENSE}) dudit courant électrique (I_{LOAD}) ;
- réalisation d'une multiplication du courant image (I_{SENSE}) par un signe d'une tension (V_{LOAD}) de la charge (Z_{LOAD})
- alimentation du résultat de ladite multiplication à un filtre (11), le filtre (11) étant configuré pour fournir un signal CC ;
- détermination d'une valeur de crête (S2) de la tension (V_{LOAD}) ;
- réalisation d'une multiplication linéaire de la sortie (S1) du filtre (11) avec la valeur de crête (S2) ; et
- fourniture d'un signal de polarisation pour le premier multiplicateur (10) lors de la mesure de la puissance électrique de la charge (Z_{LOAD}), dans lequel le signal de polarisation est essentiellement indépendant de la température et/ou du processus du premier multiplicateur (10).

11. Procédé selon la revendication 10, dans lequel la multiplication linéaire de la sortie (S1) du filtre (11) avec la valeur de crête (S2) est effectuée en numérique.

12. Procédé selon la revendication 10, dans lequel la multiplication linéaire de la sortie (S1) du filtre (11) avec la valeur de crête (S2) est effectuée en analogique.

13. Procédé selon l'une quelconque des revendications 10 à 12, comprenant en outre une adaptation d'une plage de travail du premier multiplicateur (10).
